Europäisches Patentamt

European Patent Office

Office européen des brevets

(19)

(11) Veröffentlichungsnummer: **0 126 846**
**B1**

(12) # EUROPÄISCHE PATENTSCHRIFT

(45) Veröffentlichungstag der Patentschrift: **01.08.90**

(51) Int. Cl.⁵: **G 01 D 5/20**

(21) Anmeldenummer: **84101422.8**

(22) Anmeldetag: **11.02.84**

(60) Teilanmeldung **89118944.1** eingereicht am **11/02/84**.

(54) Induktiver Sensor.

(30) Priorität: **05.12.83 DE 3343885**
**21.04.83 DE 3314440**

(43) Veröffentlichungstag der Anmeldung:
**05.12.84 Patentblatt 84/49**

(45) Bekanntmachung des Hinweises auf die
Patenterteilung:
**01.08.90 Patentblatt 90/31**

(84) Benannte Vertragsstaaten:
**AT CH DE FR GB IT LI NL SE**

(56) Entgegenhaltungen:
**AT-A- 300 410**
**DE-A-3 133 043**
**US-A-4 335 442**

**POLYTECHNISCH TIJDSCHRIFT:
ELEKTROTECHNIEK ELEKTRONICA, Band 36,
Nr. 8, August 1981, Seiten 403-407, Den Haag,
NL; G. VAN BEIJSTERVELD: "Het lineariseren
van opnemers met digitale technieken"**

(73) Patentinhaber: **WABCO Westinghouse
Fahrzeugbremsen GmbH
Am Lindener Hafen 21 Postfach 91 12 80
D-3000 Hannover 91 (DE)**

(72) Erfinder: **Ulbrich, Gerald
Sarstedter Strasse 35c
D-3000 Hannover 81 (DE)**
Erfinder: **Neuhaus, Detlev
Heinkenstrasse 1
D-3012 Langenhagen (DE)**

(74) Vertreter: **Schrödter, Manfred
WABCO Westinghouse Fahrzeugbremsen
GmbH Am Lindener Hafen 21 Postfach 91 12 80
D-3000 Hannover 91 (DE)**

EP 0 126 846 B1

**Beschreibung**

Die Erfindung bezieht sich auf einen induktiven Sensor gemäß dem Oberbegriff des Patentanspruchs 1 sowie Temperatursensoren gemäß den Ansprüchen 5 und 6.

Bei derartigen induktiven Sensoren wird durch das Verschieben eines Eisenkerns die Induktivität einer Spule verändert. Durch eine Elektronik wird diese Veränderung erfaßt und in einen Weg umgeformt.

Gebräuchlich ist es, hierzu die Spule als frequenzbestimmendes Teil eines Schwingkreises einzusetzen [DE—A—20 46 336]. Bei Induktivitätsveränderungen wird dann der Schwingkreis verstimmt. Die dadurch bewirkte Frequenzveränderung wird ausgewertet und analog in ein entsprechendes Wegsignal umgeformt.

Nachteilig an dieser Lösung ist es, daß die aktiven Bauteile des benötigten Oszillators temperaturabhängig sind, wodurch der Meßwert ungenau wird, insbesondere bei großen Temperatur-Schwankungen. Weiterhin ist die Beziehung zwischen Frequenz und Induktivität bzw. Weg des Eisenkerns mit $f = \frac{1}{2}\pi\sqrt{L \cdot C}$ nicht linear, wodurch eventuell noch eine Korrektur-Schaltung notwendig wird.

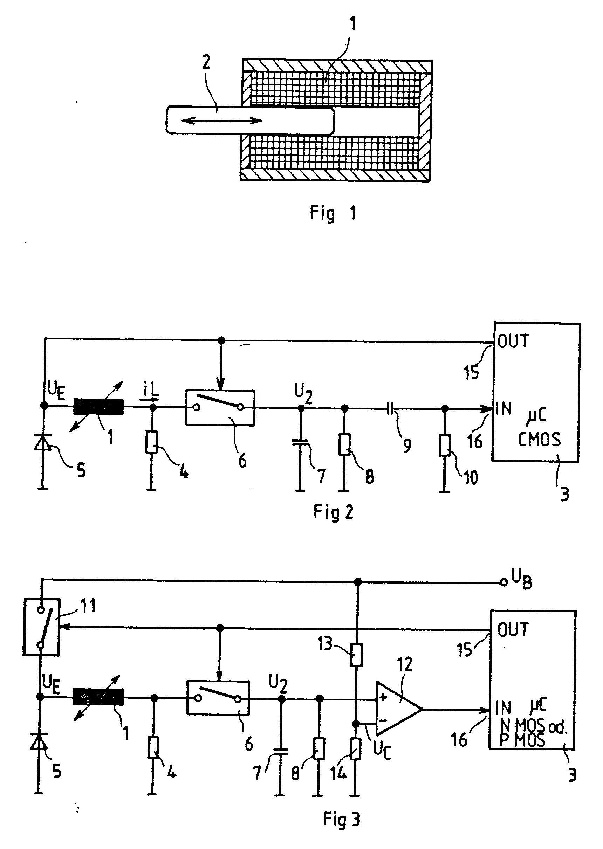

Aus der DE—A—31 33 043 ist eine Auswerteschaltung für eine druckabhängig veränderliche Induktivität bekannt, bei der die Induktivität von einem Mikrocomputer mit einer Impulsfolge vorgegebener Frequenz angesteuert wird [Fig. 2a].

Hiermit wird über einen Widerstand ein Kondensator aufgeladen. Der Kondensator entlädt sich gleichzeitig über einen weiteren Winderstand. Die Höhe der am Kondensator sich ausbildenden Spannung ist ein Maß für die Induktivität und wird nach einer A/D-Wandelung vom Mikrocomputer ausgewert. Die bekannte Schaltung braucht wegen des enthaltenen Integrationsgliedes relativ lange, bis ein gültiger Meßwert zur Verfügung steht.

Der Erfindung liegt die Aufgabe zugrunde, eine Sensor der eingangs genannten Art so auszubilden, daß die obengenannten Nachteile vermieden werden. Weiterhin soll die Elektronik einfach und preisgünstig auf aufgebaut sein.

Diese Aufgabe wird durch die im Patentanspruch 1 enthaltende Erfindung gelöst. Die abhängigen Ansprüche enthalten zweckmäßige Weiterbildungen der Erfindung.

Die Zeichnung zeigt Ausführungsbeispiele der Erfindung.

In Figur 1 ist schematisch der mechanische Teil des Sensors dargestellt.

In Figur 2 ist eine erste Variante der Auswerteelektronik dargestellt.

In Figur 3 ist eine zweite Variante der Auswerteelektronik dargestellt.

In Figur 4a - c ist ein Diagramm der Spannungen und Ströme der Elektronik nach Figur 3 über der Zeit dargestellt.

Der in Figur 1 schematisch dargestellte mechanische Teil des Sensors besteht aus einer Spule (1), in die ein beweglicher Kern (2), der z.B. aus Eisen besteht, entsprechend dem zu messenden Weg eingeschoben werden kann. Der mögliche Hub des Kerns (2) kann etwa 2 cm betragen. Das zu messende bauteil kann auch über einen Hebel angelenkt sein, so daß auch größere Verschiebungen gemessen werden können.

In Figur 2 ist eine erste Variante der Elektronik dargestellt, mit der die Induktivitätsveränderung der Spule (1) ausgewertet wird. Ein Mikrocomputer (3) in CMOS-Technik gibt an einem Ausgang (15) [OUT] einen rechteckförmigen Spannungsimpuls ab. Dieser Impuls kann z.B. eine Dauer von 10 μs und eine Höhe von 5 V haben. Mit diesem Spannungsimpuls $U_E$ wird die Spule (1) über einen Wierstand (4) angesteuert. Die Diode (5) dient als Freilaufdiode für die Spule (1).

Durch denselben Impuls $U_E$ wird ein elektronischer Schalter (6), der z.B. ein FET-Transistor sein kann, geschlossen. Hierdurch wird ein Kondensator (7) mit einer Spannung $U_E$, mit einem Teil des Spulenstroms $i_L$ der Spule (1), geladen. Die Lade-Phase wird beendet, sobald nach Beendigung des Impulses $U_E$ auch der Schalter (6) wieder öffnet. Der hierbei errichte Endwert der Spannung $U_2$ ist ein Maß für die Induktivität der Spule (1). Bei großer Inuktivität ergibt sich eine kleine Endspannung, bei kleinerer Induktivität eine große Endspannung aufgrund der unterschiedlichen Zeitkonstanten $\tau_L$ der Spule (1).

Der Kondensator (7) entlädt sich daraufhin über einen Widerstand (8). Dabei ist die Entlade-Zeitkonstante erheblich höher gewählt als die Auflade-Zeitkonstante. Über ein RC-Koppelglied (9, 10) wird die Entladespannung $U_2$ auf einen Eingang (16) [IN] des Mikrocomputers (3) übertragen. Der Mikrocomputer (3) ist so programmiert, daß er die Entladezeit bis zum Absinken von $U_2$ auf eine bestimmte Spannungs-schwelle mißt. Diese Zeit ist ein direktes maß die Induktivität bzw. den Weg.

Die Schaltung nach Figur 3 unterscheidet sich von der Schaltung nach Figur 2 im wesentlichen dadurch, daß hier ein PMOS-oder NMOS-Mikrocomputer ohne Nulldurchgangsdetektor vorgesehen ist. Am Ausgang (15) [OUT] wird wiederum ein rechteckförmiger Spannungssimpuls von etwa 5 V Höhe ausgegeben. Dieser schließt einen elektronischen Schalter (11), mit der die Versorgungsspannung $U_B$ auf die Spule (1) gegeben wird. Der folgende Teil der Schaltung ist identisch mit dem in Figur 2. Da der Mikrocomputer (3) keinen Nulldurchgangsdetektor aufweist, ist noch ein Komparator (12) vorgesehen. Mit Hilfe eines Spannungsteilers mit den Widerständen (13, 14) wird eine Schwellenspannung $U_C$ eingestellt. Sobald während des Entladevorganges die Kondensatorspannung $U_2$ diesen Schwellwert unterschritten hat, wird die Zeitmessung im Mikrocomputer (3) beendet.

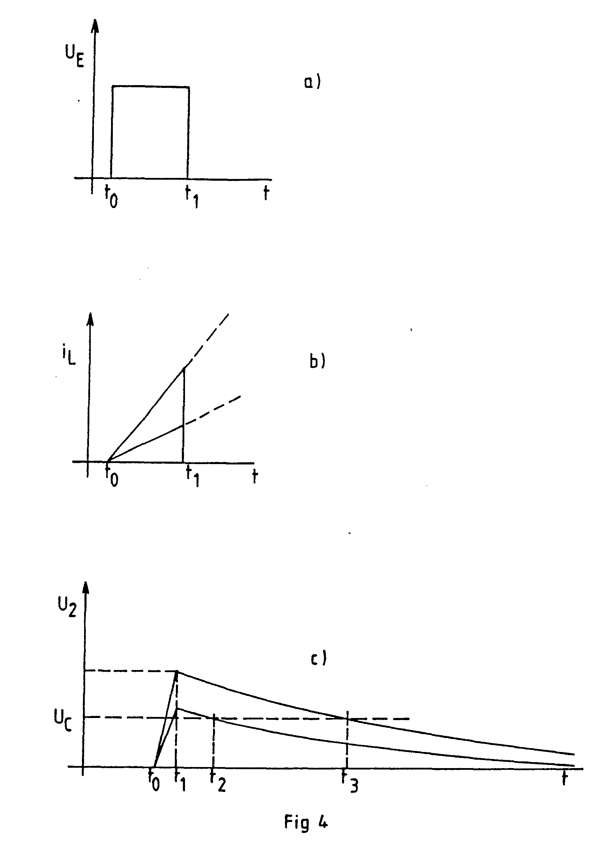

In Figur 4 sind die Verläufe von Spannungen und Strömen der Schaltung nach Figur 3 über der Zeit aufgetragen.

Figur 4a zeigt den Spannungsimpuls $U_E$, welcher vom Mikrocomputer (3) am Ausgang (15) ausgegeben wird. Dieser dauert von $t_0$ bis $t_1$ und

wird vorzugsweise immer dann ausgegeben, wenn ein Meßwert benötigt wird.

Wie in Figur 4b dargestellt ist, bewirkt der Spannungsimpuls $U_E$ in der Spule (1) einen Strom $i_L$, der gemäß einer e-Funktion ansteigt. Dieser Strom dauert ebenfalls von $t_0$ bis $t_1$. Der Spannungsimpuls $U_E$ ist so kurz gewählt, daß nur der erste, etwa lineare Teil des Ladestromes $i_L$ ausgewertet wird. Es sind heir zwei unterschiedlich hohe Ströme einge zeichnet, von denen der höhere zur kleineren Induktivität der Spule (1) gehört.

In Figur 4c ist die am Kondensator (7) anstehende Spannung $U_2$ über der Zeit aufgetragen. Ab dem Zeitpunkt $t_1$ beginnt mit dem Schließen des Schalters (6) die Entladung des Kondensators (7). Diese dauert erheblich länger als die Aufladung. Die Entladezeit wird durch einen im Mikrocomputer (3) enthaltenen Timer gemessen. Die Messung ist beendet, sobald die sinkende Entladespannung den von den Widerständen (13, 14) des Spannungsteilers gebildeten Schwellwert $U_c$ unterschritten hat. Dies ist in der Figur 4c bei einer großen Induktivität im Zeitpunkt $t_3$ der Fall. Auch hierbei wird nur der lineare Teil der Entladekurve ausgewertet.

In der Schaltung nach Figur 3 ist es möglich, den elektronischen Schalter (6) nach beendeter Messung nochmals kurz anzusteuern. Hierbei ist es jedoch erforderlich, den zweiten elektronischen Schalter (11) durch [nicht dargestellte Mittel] offenzuhalten. Der Sinn der nochmaligen Ansteuerung des Schalters (6) ist es, den Kondensator (7) über den Widerstand (4) schnell vollständig zu entladen. Hierdurch ist eine erhöhte Meßfrequenz durch den Mikrocomputer (3) möglich.

Es ist weiterhin vorteilhaft, daß im Mikrocomputer (3) eine softwaremäßige Linearisierung des Weg-Meßwertes durchgeführt wird.

Es ist auch möglich, den Ladewiderstand (4) temperaturabhängig auszuführen und die Induktivität der Spule (1) konstant zu halten. Hierdurch entsteht aus der Anordnung ein Temperatursensor. Die gleiche Wirkung erhält man bei einem Ersatz der Spule (1) durch einen temperaturabhängigen Widerstand.

Es ist auch möglich, den Spulen-Kern (2) mit einer Membran zu verbinden, und hierdurch einen Drucksensor darzustellen.

Die Schaltungen gemäß Figur 2 und Figur 3 kommen mit einem gegenüber dem Stand der Technik minimalen Bauteilaufwand aus. Bei Verwendung eines Mikrocomputers mit Nullspannungserkennung [Figur 2] kann auch der Komparator (12) [Figur 3] entfallen. Die Aufnahme des Weges durch den Mikrocomputer (3) erfolgt digital, so daß kein zusätzlicher A/D-Wandler notwendig ist.

Die maximale Auflösung der Zeitmessung im Mikrocomputer wird durch die Arbeitsfrequenz des Computers bestimmt.

Die Dauer des Spannungsimpulses $U_E$ ist konstant und ein Vielfaches eines Bits lang.

Die Auswerteelektronik nach Figur 2 oder 3 [ohne den Mikrocomputer 3] kann auch direkt im Sensor [Figur 1] integriert sein. Bei schwierigen Umgebungsbedingungen, z.B. ehr hoher Temperatur, ist es jedoch vorteilhafter, die Elektronik an geschützter Stelle anzubringen und en mechanischen Teil 1, 2, des Sensors mittels einer Leitung anzuschließen.

**Patentansprüche**

1. Induktiver Sensor, insbesondere zur Wegmessung, mit einer Spule (1) mit einem Kern (2) und einer Elektronik, welche die jeweilige von der zu bestimmenden Größe abhängige Induktivität der Spule (1) auswertet, wobei die Elektronik einen Mikrocomputer (3) enthält, welcher die Spule (1) mit einem Spannungsstoß vorgegebener Dauer anregt und aus dem resultierenden Ladestrom mittels einer Zeitmessung eine von der zu betimmenden Größe (2) abhängige Induktivitätsgröße der Spule (1) ermittelt, gekennzeichnet durch folgende Merkmale:

a) Der Kern (2) ist bezüglich der Spule (1) verschiebbar, so daß die Induktivität de Spule (1) von der Verschiebung des Kerns (2) abhängt;

b) ein Kondensator (7) ist durch den Ladestrom der Spule (1) aufladbar;

c) der Kondensator (7) entlädt sich über einen ersten Widerstand (8) mit einer gegenüber der Aufladung großen Zeitkonstante;

d) die Entladezeit des Konensators (7) wird vom Mikrocomputer (3) ausgewertet und in eine wegabhängige Größe umgerechnet.

2. Sensor nach Anspruch, 1, gekennzeichnet durch folgende Merkmale:

a) als Mikrocomputer (3) ist ein CMOS-Mikrocomputer mit Nulldurchgangsdetektor vorgesehen;

b) die Spule (1) ist an einen Ausgang (15) des Mikrocomputers (3) angeschlossen und liegt mit dem anderen Ende über einen zweiten Widerstand (4) an Masse;

c) die Spannung am zweiten Widerstand (4) ist über einen elektronischen Schalter (6) auf ein R-C-Glied, welches den ersten Widerstand (8) sowie den Kondensator (7) beinhaltet, übertragbar;

d) die Entladespannung des R-C-Gliedes (7, 8) ist über ein Koppelglied (9, 10) auf einen Eingang (16) des Mikrocomputers (3) überträgbar.

3. Sensor nach Anspruch 1, gekennzeichnet durch folgende Merkmale:

a) als Mikrocomputer (3) ist ein N-MOS- oder P-MOS-Mikrocomputer vorgesehen;

b) die Spule (1) ist über einen vom Mikrocomputer (3) gesteuerten elektronischen Schalter (11) mit einer Spannung $U_B$ ansteuerbar.

c) der Kondensator (7) ist an einen Komparator (12) angeschlossen;

d) der Ausgang des Komparators (12) ist an einen Eingang (16) des Mikrocomputers (3) angeschlossen.

4. Sensor nach Anspruch 2, dadurch gekennzeichnet, daß zur Erhöhung der möglichen Abtastfrequenz nach einer Messung der Kondensator (7) durch nochmaliges Ansteuern des Schalters (6) über den zweiten Widerstand (4) schnell entladbar ist.

5. Sensor nach Anspruch 4, dadurch gekennzeichnet, daß zur Temperatur-messung der zweite Widerstand (4) temperaturabhängig und die Induktivität der Spule (1) konstant ist, wobei die Entladezeit des Kondensators (7) eine Maß für die Größe des temperaturabhängigen Widerstands und damit für die zu bestimmende Temperatur bildet.

6. Sensor nach wenigstens einem der Ansprüche 1 bis 4, dadurch gekennzeichnet, daß zur Temperaturmessung die Spule (1) durch einen temperaturabhängigen Widerstand ersetzt ist, wobei die Entladezeit des Konensators (7) eine Maß für die Größe des temperaturabhängigen Widerstands und damit für die zu bestimmende Temperatur bildet.

7. Sensor nach wenigstens einem der Ansprüche 1 bis 4, dadurch gekennzeichnet, daß zur Kern (2) mit einer Druck-Membran verbunden ist.

8. Sensor nach Anspruch 7, dadurch gekennzeichnet, daß durch den Mikrocomputer (3) eine softwaremäßige Linearisierung des Meßwertes durchgeführt wird.

**Revendications**

1. Capteur inductif, notamment pour la mesure de déplacements, comportant un bobine (1), un noyau (2) et une électronique interprétant l'inductance momentanée de la bobine (1) qui dépend de la grandeur à déterminer, cette électronique contenant un microcalculateur (3) qui excite la bobine (1) par une impulsion de tension de durée prédéterminée et qui, à partir du courant de charge résultant, détermine au moyen d'une mesure de temps une grandeur d'inductance de la bobine (1) dépendant de la grandeur (2) à déterminer, caractérisé par les caractéristiques suivantes:

a) le noyau (2) est mobile par rapport à la bobine (1), de sorte que l'inductance de la bobine (1) dépend du déplacement du noyau (2);

b) un condensateur (7) peut être chargé par le courant de charge de la bobine (1);

c) le condensateur (7) se décharge par une première résistance (8), avec une constante de temps grande par rapport à la charge;

d) le temps de décharge du condensateur (7) est interprété par le microcalculateur (3) et converti en une grandeur dépendant du déplacement.

2. Capteur selon revendication 1, caractérisé par les caractéristiques suivantes:

a) c'est un microcalculateur CMOS avec détecteur de passage par zéro qui est prévu en tant que microcalculateur (3);

b) la bobine (1) est raccordée à une sortie (15) du microcalculateur (3) et, par son autre extrémité, est reliée à la masse par l'intermédiaire d'une deuxième résistance (4);

c) la tension à la deuxième résistance (4) peut être transmise, par un interrupteur électronique (6), à un élément R—C qui comporte la première résistance (8) ainsi que le condensateur (7);

d) la tension de décharge de l'élément R—C (7, 8) peut être transmise, par l'intermédiaire d'un organe de couplage (9, 10), à une entrée (16) du microcalculateur (3).

3. Capteur selon revendication 1, caractérisé par les caractéristiques suivantes:

a) c'est un microcalculateur N-MOS ou P-MOS qui est prévu en tant que microcalculateur (3);

b) la bobine (1) être attaquée par une tension $U_B$ par un interrupteur électronique (11) commandé par le microcalculateur (3);

c) le condensateur (7) est raccordé à un comparateur (12);

d) la sortie du comparateur (12) est raccordée à une entrée (16) du microcalculateur (3).

4. Capteur selon revendication 2, caractérisé par le fait qu'afin d'accroître la fréquence de lecture possible, le condensateur (7) peut, après une mesure, être déchargé dans la deuxième résistance (4), par commande réitérée de l'interrupteur (6).

5. Capteur selon revendication 4, caractérisé par le fait que, pour la mesure de température, la deuxième résistance (4) dépend de la température et l'inductance de la bobine (1) est constante, le temps de décharge du condensateur (7) constituant une mesure de la grandeur de la résistance dépendant de la température, et par conséquent une mesure de la température à déterminer.

6. Capteur selon au moins l'une des revendications 1 à 4, caractérisé par le fait que, pour la mesure de température, la bobine est remplacée par une résistance dépendant de la température, le temps de décharge du condensateur (7) constituant une mesure de la grandeur de la résistance dépendant de la température, donc une mesure de la température à déterminer.

7. Capteur selon au moins une des revendications 1 à 4, caractérisé par le fait que le noyau (2) est lié à une membrane pour pression.

8. Capteur selon revendication 7, caractérisé par le fait que le microcalculateur (3) exécute, par logiciel, une linéarisation de la valeur de mesure.

**Claims**

1. An inductive sensor, in particular for measuring displacement, with a coil (1) having a core (2) and with electronics which evaluate the particular inductance, dependent on the variable to be determined, of the coil (1), the electronics containing a microcomputer (3) which excites the coil (1) with a voltage impulse of given duration and from the resulting charging current determines, by means of a time measurement, an inductance value, dependent on the variable to be determined, of the coil (1), characterized by the following features:

a) the core (2) is displaceable relative to the coil (1) so that the inductance of the coil (1) depends on the displacement of the core (2);

b) a capacitor (7) is chargeable by the charging current of the coil (1);

c) the capacitor (7) discharges by way of a first resistor (8) with a long time constant compared with the charging;

d) the discharging time of the capacitor (7) is evaluated by the microcomputer (3) and converted into a displacement-dependent variable.

2. A sensor according to claim 1, characterized by the following features:

a) as microcomputer (3) there is provided a CMOS-microcomputer with a zero-crossing detector;

b) the coil (1) is connected to an output (15) of the microcomputer (3) and with its other end is earthed by way of a second resistor (4);

c) the voltage at the second resistor (4) is transferrable by way of an electronic switch (6) to an RC element which contains the first resistor (8) and the capacitor (7);

d) the discharge voltage of the RC element (7, 8) is transferrable by way of an electronic coupling element (9, 10) to an iput (16) of the microcomputer (3).

3. A sensor according to claim 1, characterized by the following features:

a) as microcomputer (3) there is provided an NMOS or PMOS microcomputer;

b) the coil (1) is triggerable with a voltage $U_B$ by way of an electronic switch (11) controlled by the microcomputer (3);

c) the capacitor (7) is connected to a comparator (12);

d) the output of the comparator (12) is connected to an input (16) of the microcomputer (3).

4. A sensor according to claim 2, characterized in that, to increase the possible sensing frequency, after a measurement the capacitor (7) is rapidly dischargeable in response to renewed triggering of the switch (6) by way of the second resistor (4).

5. A sensor according to claim 4, characterized in that, for tempeature measurement, the second resistor (4) is temperature-dependent and the inductance of the coil (1) is constant, the discharging time of the capacitor (7) forming a measure of the variable of the temperature-dependant resistor and thus of the temperature to be determined.

6. A sensor according to at least one of claims 1 to 4, characterized in that, for temperature measurement, the coil (1) is replaced by a temperature-dependent resistor, the discharging time of the capacitor (7) forming a measure of the variable of the temperature-dependant resistor and thus of the temperature to be determined.

7. A sensor according to at least one of claims 1 to 4, characterized in that the core (2) is connected to a pressure diaphragm.

8. A sensor acccording to claim 7, characterized in that a software linearisation of the measured value is carried out by the microcomputer (3).

Fig 1

Fig 2

Fig 3

Fig 4